Europäisches Patentamt

European Patent Office

Office européen des brevets

(19)

(11) Numéro de publication : **0 616 484 A1**

(12) # DEMANDE DE BREVET EUROPEEN

(21) Numéro de dépôt : **94400559.4**

(22) Date de dépôt : **15.03.94**

(51) Int. Cl.⁵ : **H04R 15/00, G01R 33/06**

(30) Priorité : **19.03.93 FR 9303206**

(43) Date de publication de la demande :
**21.09.94 Bulletin 94/38**

(84) Etats contractants désignés :
**DE GB**

(71) Demandeur : **THOMSON-CSF**
**173, Boulevard Haussmann**
**F-75008 Paris (FR)**

(72) Inventeur : **Etienne, Patrick**
**THOMSON-CSF,**
**SCPI,**
**B.P. 329**
**F-92402 Courbevoie Cedex (FR)**
Inventeur : **Schuhl, Alain**
**THOMSON-CSF,**
**SCPI,**
**B.P. 329**
**F-92402 Courbevoie Cedex (FR)**

(74) Mandataire : **Guérin, Michel et al**
**THOMSON-CSF**
**SCPI**
**B.P. 329**
**50, rue Jean-Pierre Timbaud**
**F-92402 Courbevoie Cédex (FR)**

(54) **Transducteur magnétorésistif et procédé de réalisation.**

(57)    Détecteur magnétorésistif comportant un empilement (1) de couches de caractéristiques magnétiques différentes (multicouches métalliques magnétiques) dans lequel on prévoit sous l'effet d'un champ électrique, un transport d'électrons perpendiculaire aux couches.
    Pour assurer plusieurs transferts perpendiculaires à travers le même empilement de couches, celui-ci est enserré entre deux électrodes (4, 5) et la conduction électrique de l'ensemble est interrompue par une découpe de la structure sous forme de créneaux "grecques".

FIG.2a

EP 0 616 484 A1

L'invention concerne un transducteur magnétorésistif et un procédé de réalisation d'un tel transducteur.

Le transport électronique dans les Multicouches Métalliques Magnétiques (MMM) a été étudié durant ces dernières années car il permet l'étude des propriétés de magnéto-résistance d'un matériau considéré. Ce phénomène a pour origine la différence de résistivité du matériau, sous champ magnétique externe, ou en l'absence de ce champ, liée à la variation des propriétés des interfaces.

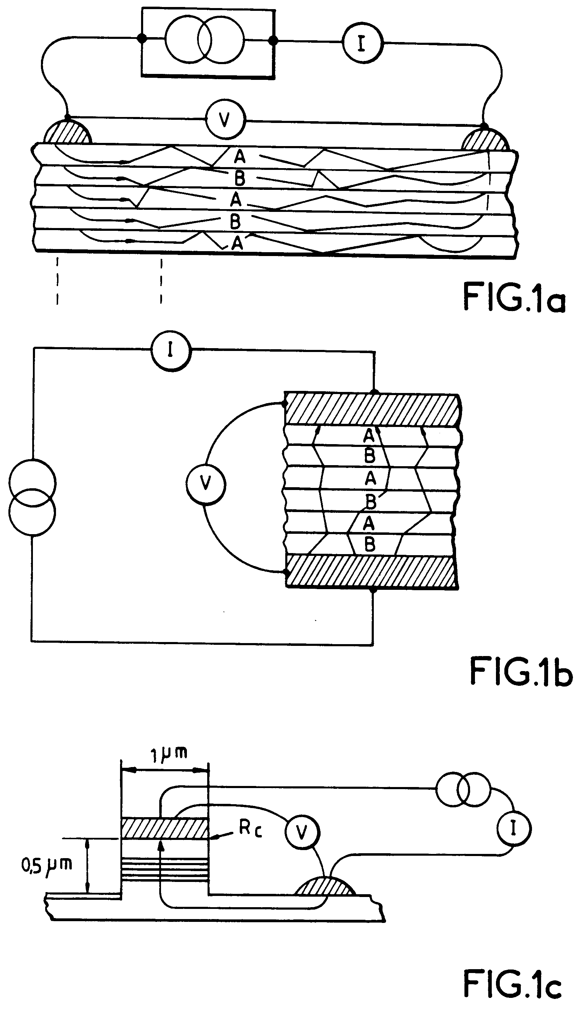

Sur la figure 1a, un matériau de type A, par exemple, est magnétique tandis qu'un matériau de type B est non magnétique.

Pour des raisons pratiques les mesures ne sont en général faites qu'en appliquant un champ électrique parallèlement aux plans des couches. Dans ce cas, si la longueur de diffusion (5 à 100 nm) est supérieure à l'épaisseur des couches (1 à 5 nm). Le trajet d'un électron avant de rencontrer une interface peut être grand. La solution qui consisterait à appliquer un champ électrique perpendiculairement aux plans des couches (figure 1b) serait donc beaucoup plus favorable pour une meilleure exploitation de la magnéto-résistance puisqu'alors les électrons rencontreraient rapidement une interface. Cette idée circule donc depuis quelques années mais elle est très difficile à réaliser techniquement et l'objet de l'invention réside dans une solution contournant ces difficultés.

Des réalisations pratiques fonctionnant par mesure du courant perpendiculairement au plan des couches, peuvent prendre la forme représentée en figure 1c.

On peut alors noter que :

1°/ La résistivité des matériaux étant faible (environ $10^{-5}$ $\Omega$.cm) les résistances à mesurer sont très faibles :

Par exemple :

$$R = 10^{-5} \times \frac{5 \times 10^{-5}}{(\pi/4)10^{-8}} = 6{,}36 \times 10^{-2}\Omega$$

2°/ La résistance de contact Rc est en proportion élevée car la surface de contact est faible (quelques $\mu m^2$).

3°/ La technologie est peu connue et difficile.

4°/ Les courants à mesurer sont faibles car on ne peut pas faire passer beaucoup de courant (en comparaison avec le transport parallèle aux couches).

5°/ Il est impossible avec les solutions classiquement envisagées de placer un objet ayant une information magnétique près du dispositif de détection (les prises de contacts empêchent la proximité du support contenant l'information).

Ces raisons font qu'il n'y a pas eu d'études cohérentes faites à température ambiante à ce jour et que seules des mesures à basse température ont été réalisées en utilisant des connexions supraconductrices qui limitent bien sûr les observations au seul domaine des basses températures. On n'envisage donc pas actuellement la réalisation de capteurs ayant l'avantage du transport perpendiculaire et fonctionnant à température ambiante.

L'invention concerne donc un procédé caractérisé en ce que l'interruption est réalisée par gravure.

L'invention concerne également un transducteur magnétorésistif comportant au moins une couche d'un matériau composite comportant au moins deux types de particules de caractéristiques magnétiques différentes, caractérisé en ce qu'il comporte également:

- deux couches de matériau conducteur enserrant la couche de matériau composite;
- au moins deux électrodes situées sur au moins une des couches de matériaux conducteur en des zones distantes l'une de l'autre selon le plan des couches ;

la couche de matériau composite et une couche de matériau conducteur qui porte une électrode comportant au moins une interruption du point de vue conduction électrique située entre les zones comportant les électrodes.

En application de ce qui précède, le transducteur magnétorésistif comporte plusieurs interruptions d'ordre pair et d'ordre impair, les interruptions d'ordre pair interrompant la conduction électrique de l'une des couches de matériau conducteur tandis que les interruptions d'ordre impair interrompent la conduction électrique de l'autre couche de matériau conducteur.

Enfin l'invention concerne un procédé de réalisation d'un transducteur magnétorésistif caractérisé en ce qu'il comporte les étapes suivantes :

a) - réalisation d'un empilement d'au moins les couches suivantes :

- une première couche de matériau conducteur
- au moins une couche de matériau composite comportant des particules de matériau magnétique et des particules de matériau non magnétique
- une deuxième couche de matériau conducteur

b) - réalisation d'au moins une interruption de conduction électrique dans l'une des couches de matériau conducteur et dans la couche de matériau composite.

Les différents objets et caractéristiques de l'invention apparaîtront plus clairement dans la description qui va suivre faite à titre non limitatif dans les figures annexées qui représentent :

- les figures 1a à 1c, des dispositifs connus dans la technique;
- les figures 2a, 2b, 2c, des exemples de réalisation du dispositif de l'invention;
- la figure 3, une variante de réalisation du dispositif de l'invention ;
- les figures 4a à 4d, un procédé de réalisation du dispositif de l'invention;
- les figures 5a à 5b, un autre procédé de réalisation du dispositif de l'invention.

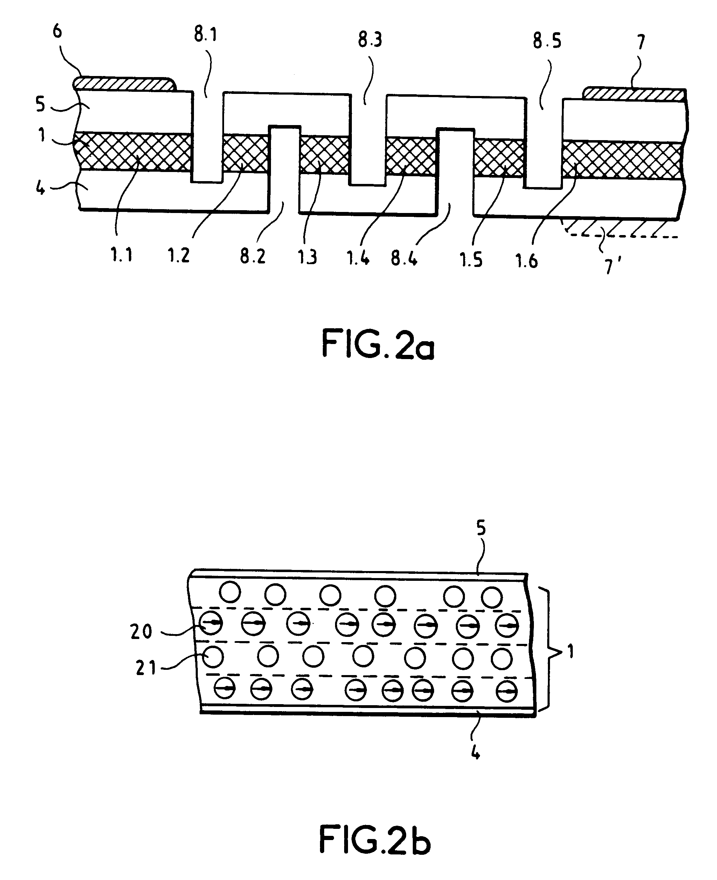

En se reportant à la figure 2a on va donc décrire un dispositif de base selon l'invention.

Ce dispositif comporte une couche 1 d'un matériau composite constitué de particules en matériau magnétique et de particules en matériau isolant ou semiconducteur. Cette couche est enserrée entre deux couches 4 et 5 en matériaux conducteurs. L'une des couches conductrices, 5 par exemple, porte deux électrodes 6 et 7 situées à deux extrémités opposées de la couche 5. Les électrodes pourraient être également l'une sur la couche 5, l'autre sur la couche 4. Par exemple, l'électrode 7 pourrait être à l'emplacement noté 7' sur la figure 2a.

L'empilement de couche comporte au moins une interruption du point de vue de la conduction électrique, cette interruption affectant la couche 1 et au moins une couche conductrice 4 et 5.

Une réalisation pratique préférée prévoit plusieurs interruptions. Des interruptions d'ordre impair 8.1, 8.3, 8.5 sont pratiquées dans la couche conductrice 5 et dans la couche 1. Des interruptions d'ordre pair 8.2, 8.4 sont pratiquées dans la couche conductrice 4 et dans la couche 1. Ainsi un courant qui devrait circuler entre les électrodes 6 et 7 devra passer par les différents éléments 1.1 à 1.6.

Du point de vue fonctionnel, la structure de la figure 2a fonctionne donc comme si on avait empilé les différents éléments 1.1 à 1.6. Par ailleurs, la surface des électrodes 6 et 7 peut être très grande, donc sa résistance faible devant celle des éléments 1.2 à 1.5.

Cette invention s'applique également à du matériau granulaire. On peut prévoir alors d'arranger les particules dans la couche 1 selon une répartition déterminée. Notamment, selon la figure 2b, on prévoit des couches alternées de particules de types différents.

Par exemple, en prévoyant des particules 20 dont l'aimantation est fixée et est insensible au champ à détecter et des particules 21 dont l'aimantation est sensible au champ à détecter, on dispose différentes couches dont certaines comportent des particules 20 et d'autres des particules 21. En prévoyant des couches suffisamment minces on peut obtenir un dispositif dans lequel, selon la direction perpendiculaire aux plans des couches, une particule 21 n'a comme premières particules voisines, des particules 20 et réciproquement. De cette façon, les jonctions tunnels entre particules de même type ne percolent pas à travers le matériau.

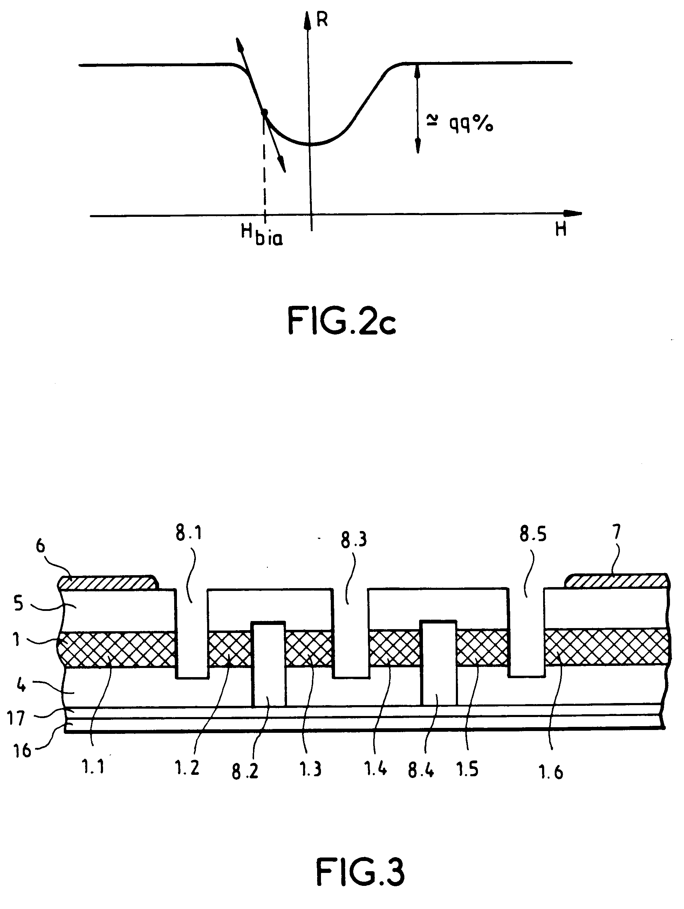

La variation de résistivité en fonction du champ magnétique suit la loi de variation représentée en figure 2c. On prévoit donc de pouvoir fonctionner dans une zone de variation linéaire fournissant une bonne sensibilité de détection. Pour cela on applique un champ magnétique continu, par exemple $H_{bias}$ sur la figure 3a, ce qui permet de fonctionner dans une zone linéaire de la courbe.

Les moyens permettant d'appliquer ce champ magnétique continu pourront être un aimant permanent tel qu'une couche d'un matériau aimanté 16 représentée sur la figure 3. Cette couche 16 peut être une couche mince ou épaisse selon l'intensité d'aimantation induite et selon l'épaisseur de la couche 1. Elle peut être isolée de la couche 4 par une couche d'isolation 17.

On peut également prévoir une boucle conductrice de l'électricité permettant d'induire un champ magnétique dans la couche 1. Cette boucle conductrice non représentée prend alors la place de la couche 16.

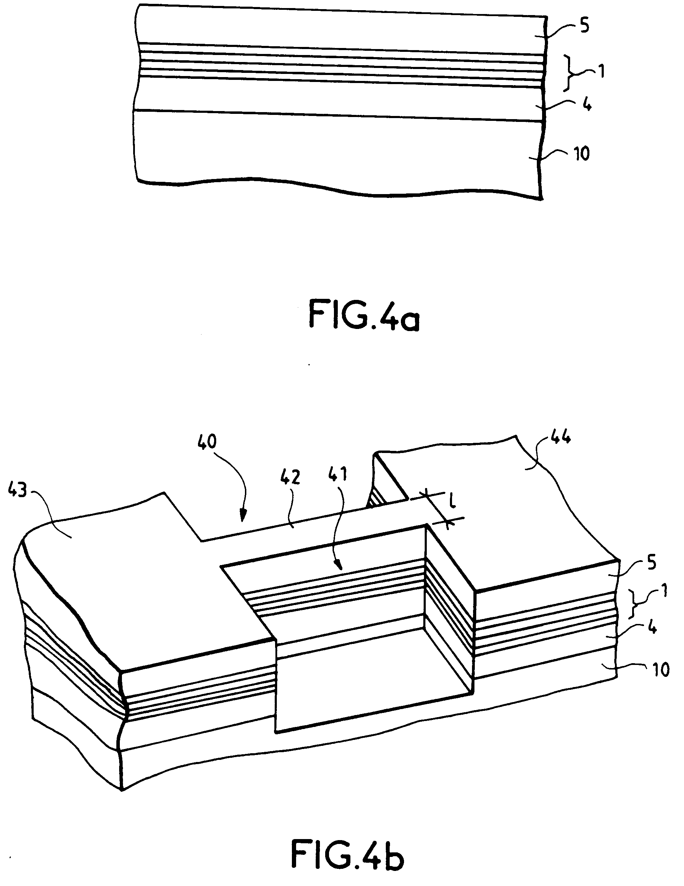

En se reportant aux figures 4a à 4d, on va maintenant décrire un procédé de réalisation selon l'invention.

On réalise sur un substrat 10 en matériau isolant l'empilement de couches suivantes:
- une couche 4 d'un matériau conducteur,
- une couche 1 d'un matériau composite tel que décrit précédemment, réalisé par exemple sous forme d'un empilement de sous-couches de caractéristiques magnétiques différentes,
- ne couche 5 d'un matériau conducteur.

On a ainsi l'empilement de couches de la figure 4a.

La solution proposée est schématisée en figure 4a. Elle est réalisée à partir d'une multicouche de matériau A et B intercalée entre 2 couches d'un matériau C celui-ci étant bon conducteur (on appellera cet ensemble "dépôt métallique").

On creuse ensuite (figure 4b) deux découpes rectangulaires 40 et 41 au moins jusqu'au substrat 1 de telle manière à ne laisser qu'un ruban 42 de faible largeur (par exemple li 1 μm) les arrivées de courant 43, 44 situées de part et d'autre du ruban sont constituées par un dépôt métallique et auront une grande dimension afin de présenter une faible résistance $R_a$. Sur ces arrivées ont peut déposer les électrodes 6, 7 de grandes dimensions et donc avoir des résistances de contacts $R_c$ faibles elles aussi.

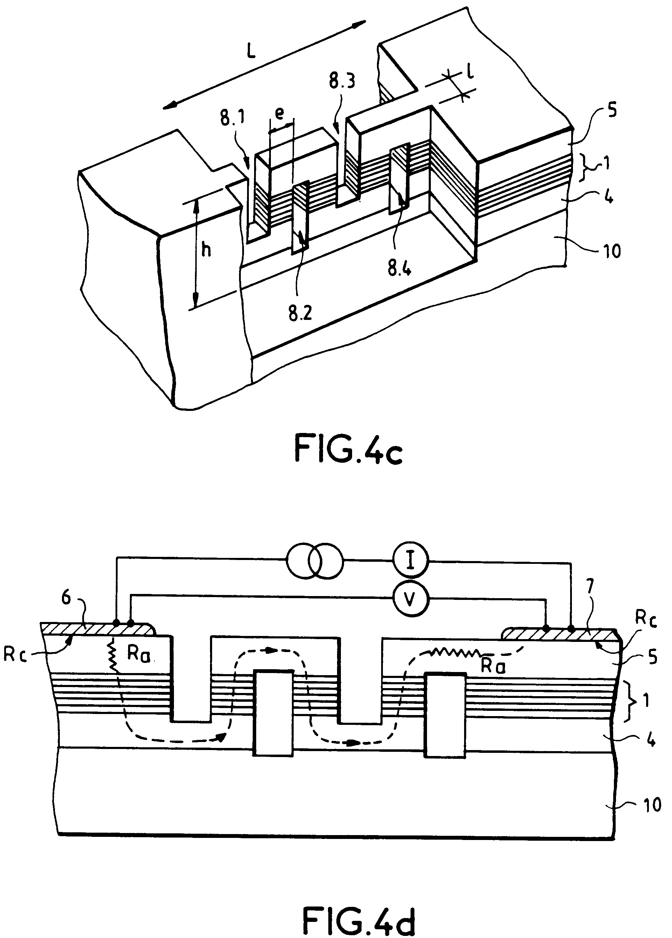

Ensuite on creuse latéralement des motifs 8.1, 8.2, ..., 8.4 obligeant le courant à circuler perpendiculairement aux couches à analyser. Dans l'exemple représenté figure 4c on peut utiliser un faisceau d'ions focalisés (Focus Ion Beam) pour creuser le ruban de façon à obtenir un motif en forme de créneaux ou de motifs "grecque". L'espacement entre les ouvertures peut être réduit à des tailles inférieures à 1 μm.

A titre d'exemple la structure de la figure 4c peut avoir les dimensions suivantes:
- épaisseur I du ruban : environ 1 μm
- hauteur h du ruban : environ 2,5 μm
- longueur L du ruban (selon le nombre d'ouvertures réalisés) : environ 10 μm.

Sur la figure 4d on représente alors le trajet effectué par le courant. La multicouche métallique est traversée, dans cet exemple, 4 fois par un courant perpendiculaire au plan du dépôt mais il est évident qu'on peut multiplier le nombre de passages autant de fois qu'on le veut. La section dans laquelle passe le courant à de faibles dimensions (donc une forte résistance) c'est-à-dire ici 1 μm de largeur de ruban par 1 μm d'espacement.

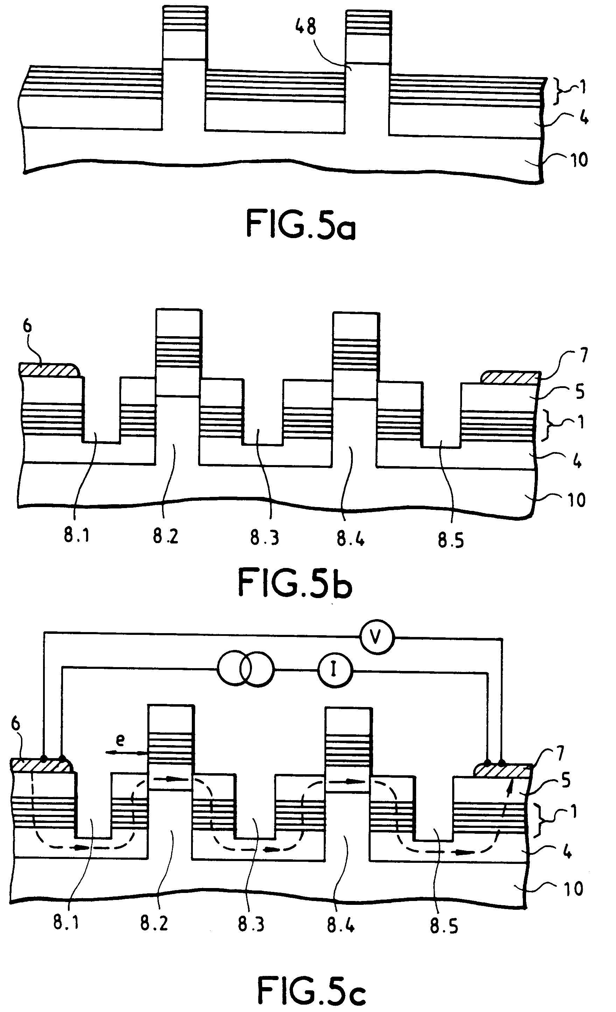

Un autre exemple de procédé consiste à effectuer les opérations schématisées par les figures 5a à 5c.

Sur un substrat 10 gravé (chimiquement ou par érosion ionique) et présentant des créneaux (48) de petites largeurs (environ 1 μm) est déposée la première couche de matériau conducteur 4 puis la couche de matériau composite 1. On obtient la structure de la figure 5a. Ensuite on dépose la deuxième couche de matériau conducteur 5 (figure 5b).

La hauteur du créneau h est prévue supérieure à l'épaisseur de la première couche de matériau conducteur 4 augmentée de l'épaisseur de la couche 1 mais inférieure à la hauteur totale du dépôt (première couche 4, couche 1, deuxième couche 5). Il y a des raccordements électriques entre la première couche conductrice 4 située sur le créneau 48 et les deuxièmes couches conductrices 5 situées de part et d'autre du créneau 48, ce qui assure la continuité électrique au-dessus du créneau.

Il suffit alors par exemple par lithographie classique (ou par d'autres moyens) de creuser des sillons 8.1, 8.3 comme représenté figure 5c pour obtenir un trajet du courant perpendiculaire aux couches 1 de matériau composite comme cela est représenté en figure 5c. Cela permet l'exploitation du phénomène avec les avantages précédemment décrits.

Le dispositif ainsi décrit peut être réalisé, par exemple, avec les matériaux et les épaisseurs suivants :
- couches en matériaux conducteurs 4,5 : métal amagnétique tel que l'argent de 1,5 μm d'épaisseur;
- couche en matériau composite 1 : multicouches d'argent et de cobalt, les couches d'argent pouvant avoir 8 nm d'épaisseur et les couches de cobalt, 2 nm d'épaisseur. On peut prévoir une quarantaine de couches d'argent alternées avec une quarantaine de couches de cobalt.

Le dispositif ainsi conçu permet de minimiser les résistances de contacts $R_c$ des électrodes et les résistances d'accès $R_a$ situées entre les électrodes et zones sensibles du dispositif par rapport à la résistance du dispositif. En effet, la largeur e de chaque élément du dispositif peut être de l'ordre du micromètre et plusieurs éléments sont mis en série, ce qui augmente considérablement la résistance du dispositif par rapport aux résistances $R_c$ et $R_a$.

Dans ce qui précède on a considéré que la couche de matériau composite 1 est constituée de deux matériaux (deux types de particules) mais il est bien évident qu'il est possible de prévoir un matériau composite constitué de plus de deux types de matériaux.

De même on a prévu une structure en forme de "grecque" (figures 4d, 5c) mais on pourrait prévoir tout autre forme qui permettrait d'avoir un transport électronique perpendiculaire aux couches de matériau composite.

Dans une application capteur magnétique, l'invention présente l'avantage de pouvoir placer le transducteur à proximité d'un support d'informations magnétiques à lire. Par exemple, on peut faire une bande magnétique près du transducteur sans être gêné par les électrodes.

**Revendications**

1. Transducteur magnétorésistif comportant au moins une couche (1) d'un matériau composite comportant au moins deux types de particules (2, 3) de caractéristiques magnétiques différentes, caractérisé en ce qu'il comporte également :
   - deux couches de matériau conducteur (4, 5) enserrant la couche (1) de matériau composite;
   - au moins deux électrodes (6, 7) situées sur au moins une des couches de matériaux conducteur (4, 5) en des zones distantes l'une de l'autre selon le plan des couches ;
   la couche de matériau composite (1) et une couche de matériau conducteur (4, 5) qui porte une électrode comportant au moins une interruption (8) du point de vue conduction électrique située entre les zones comportant les électrodes.

2. Transducteur selon la revendication 1, caractérisé en ce que la couche de matériau composite comporte au moins des particules (2) de matériau magnétique et des particules (3) de matériau non magnétique.

3. Transducteur selon la revendication 1, caractérisé en ce qu'il comporte plusieurs interruptions d'ordre pair et d'ordre impair, les interruptions d'ordre pair (8.2, 8.4) interrompant la conduction électrique de l'une des couches de matériau conducteur (4) tandis que les interruptions d'ordre impair (8.1, 8.3) interrompent la conduction électrique de l'autre couche de matériau conducteur (5).

4. Transducteur selon la revendication 2, caractérisé en ce que les électrodes (6, 7) sont situées sur une même couche de matériau conducteur (4, 5).

5. Transducteur selon la revendication 2, caractérisé en ce que chaque interruption comporte un matériau isolant.

6. Transducteur selon la revendication 2, caractérisé en ce que les particules de matériau magnétique sont superparamagnétiques.

7. Transducteur selon la revendication 2, caractérisé en ce que les particules de matériau magnétique possèdent un champ coercitif très faible.

8. Transducteur selon la revendication 2, caractérisé en ce qu'il comporte des moyens pour appliquer un champ magnétique permanent de polarisation.

9. Transducteur selon la revendication 8, caractérisé en ce qu'il comporte un aimant permanent.

10. Transducteur selon la revendication 9, caractérisé en ce que l'aimant permanent est constitué par une couche mince d'un matériau magnétique.

11. Transducteur selon la revendication 9, caractérisé en ce que l'aimant permanent comporte une boucle conductrice parcourue par un courant continu.

12. Transducteur selon la revendication 2, caractérisé en ce que les particules sont toutes d'un même matériau.

13. Transducteur selon la revendication 2, caractérisé en ce qu'il comporte au moins deux types de particules :
    - des particules d'un premier type en matériau insensible au champ à détecter ;
    - des particules d'un deuxième type en matériau sensible au champ à détecter.

14. Transducteur selon la revendication 13, caractérisé en ce que les particules sont réparties de façon à avoir des couches alternées de particules du premier type et du second type parallèles au plan des couches de matériau conducteur (4, 5).

15. Transducteur selon la revendication 14, caractérisé en ce que les particules du premier type ont leur magnétisation permanente dirigée parallèlement à une direction définie.

16. Procédé de réalisation d'un transducteur magnétorésistif caractérisé en ce qu'il comporte les étapes suivantes :
    a) - réalisation d'un empilement d'au moins les couches suivantes :
       • une première couche de matériau conducteur (4)
       • au moins une couche de matériau composite (1) comportant des particules de matériau magnétique (2) et des particules de matériau non magnétique (3) et isolant ou semiconducteur
       • une deuxième couche de matériau conducteur (5)
    b) - réalisation d'au moins une interruption de conduction électrique dans l'une des couches de matériau conducteur (4, 5) et dans la couche de matériau composite (1).

17. Procédé selon la revendication 16, caractérisé en ce que l'interruption est réalisée par gravure.

18. Procédé selon la revendication 16, caractérisé en ce qu'il comporte la réalisation de plusieurs interruptions d'ordre pair et d'ordre impair, les interruptions d'ordre pair (8.2, 8.4) interrompant la conduction électrique de l'une des couches de matériau conducteur (4) tandis que les interruptions d'ordre impair (8.1, 8.3) interrompent la conduction électrique de l'autre couche de matériau conducteur conducteur (5).

19. Procédé selon la revendication 16, caractérisé en ce que la réalisation de la couche de matériau composite (1) se fait par réalisation de sous-couches alternées de matériau de particules insensibles au champ magnétique et de matériau de particules dont l'aimantation sensible au champ magnétique.

20. Procédé selon la revendication 16, caractérisé en ce que la première couche de matériau conducteur (4) est réalisée sur un substrat (10) en matériau isolant comportant au moins un bossage de hauteur comprise entre la somme des épaisseurs de la première couche (4) et de la couche de matériau composite (1) et la somme des épaisseurs des trois couches (4, 1, 5).

21. Transducteur magnétorésistif caractérisé en ce qu'il comporte au moins deux éléments comportant chacun une couche d'un matériau (1) composée de deux types de matériaux (2, 3) de caractéristiques magnétiques différentes et enserrée entre deux couches de matériaux conducteurs (4, 5), les éléments étant connectés deux à deux par l'une des couches de matériaux conducteurs et la section de chaque élément selon un plan parallèle au plan des couches étant compris entre quelques centièmes et quelques dizaines de micromètres carrés.

FIG.1a

FIG.1b

FIG.1c

FIG.2a

FIG.2b

FIG.2c

FIG.3

8

FIG.4a

FIG.4b

FIG.4c

FIG.4d

FIG.5a

FIG.5b

FIG.5c

**Office européen
des brevets**

# RAPPORT DE RECHERCHE EUROPEENNE

Numero de la demande

EP 94 40 0559

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.5) |
|---|---|---|---|
| A | EP-A-0 221 540 (SONY) 13 Mai 1987<br>* page 6, ligne 12 - page 7, ligne 25 *<br>* page 9, ligne 16 - page 10, ligne 22 *<br>* page 16, ligne 1 - page 23, ligne 8 *<br>* page 26, ligne 7 - page 29, ligne 1 *<br>--- | 1-21 | H04R15/00<br>G01R33/06 |
| A | EP-A-0 152 000 (HITACHI) 21 Août 1985<br><br><br>* page 1, ligne 1-4 *<br>* page 4, ligne 7-17 *<br>* page 5, ligne 5 - page 7, ligne 21 *<br>* page 8, ligne 9-24 *<br>* page 15, ligne 14 - page 17, ligne 25 *<br>* page 33, ligne 18 - page 43, ligne 25 *<br>* page 47, ligne 11 - page 53, ligne 20 *<br>--- | 1,2,4,<br>6-16,19,<br>21 | |
| A | EP-A-0 406 060 (THOMSON) 2 Janvier 1991<br><br><br>* colonne 1, ligne 32 - colonne 2, ligne 12 *<br>* colonne 3, ligne 16 - colonne 6, ligne 1 *<br>----- | 1,2,6,7,<br>12-15,<br>19,21 | |

DOMAINES TECHNIQUES
RECHERCHES (Int.Cl.5)

H04R
G01R
G11B

Le présent rapport a été établi pour toutes les revendications

| Lieu de la recherche | Date d'achèvement de la recherche | Examinateur |
|---|---|---|
| LA HAYE | 22 Juin 1994 | Zanti, P |

**CATEGORIE DES DOCUMENTS CITES**

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

.....................................................................

& : membre de la même famille, document correspondant

EPO FORM 1503 03.82 (P04C08)